# EUROPEAN PATENT SPECIFICATION

(11) **EP 2 507 186 B1**
(45) Date of publication and mention of the grant of the patent: **12.11.2014**
(21) Application number: 10787432.3
(22) Date of filing: 03.12.2010
(51) Int. Cl.: C03C 17/30, C08J 7/04, C09D 4/00, C09D 183/04, C09J 5/02, H01L 21/00

(54) **SURFACE TREATMENTS AND COATINGS**
OBERFLÄCHENBEHANDLUNGEN UND BESCHICHTUNGEN
TRAITEMENTS DE SURFACE ET REVÊTEMENTS

(30) Priority: 04.12.2009 US 266611 P
(43) Date of publication of application: 10.10.2012
(73) Proprietor: Oclaro Technology Limited, Caswell Towcester Northamptonshire NN12 8EQ (GB); Loughborough University, Leicestershire LE11 3TU (GB)
(72) Inventor: WILLIAMS, Owain, Norwich Norfolk NR6 6DD (GB); LIU, Changqing, Loughborough Leicestershire LE11 3RX (GB); WEBB, Patrick, Loughborough Leicestershire LE11 2RN (GB); FIRTH, Paul, Nr Totnes Devon TQ9 6OL (GB)
(74) Representative: Mitchell, Matthew Benedict David
(86) International application number: PCT/EP2010/068858
(87) International publication number: WO 2011/067383

(56) References cited:
- WO-A2-01/77245
- US-A1- 2009 075 087

## Description

### TECHNICAL FIELD

The present invention relates to the field of surface treatments and coatings, and in particular to surface treatments and coatings to reduce adhesive spread on a substrate.

### BACKGROUND

Liquid adhesives are widely used in the manufacture of electronic and optoelectronic components. Epoxy adhesives are commonly used because they are strong and have long life-times in harsh or otherwise demanding environments. They are typically cured using UV light or thermally. As components have become smaller, adhesive management has become more important. The control of the flow of adhesive can be achieved by control of parameters such as viscosity, temperature and cure time. The less adhesive spreads from the area of the joint between the materials to be joined, the less adhesive is used. This in turn leads to less interference between an affixed component and adjacent items in the electronic/optoelectronic product.

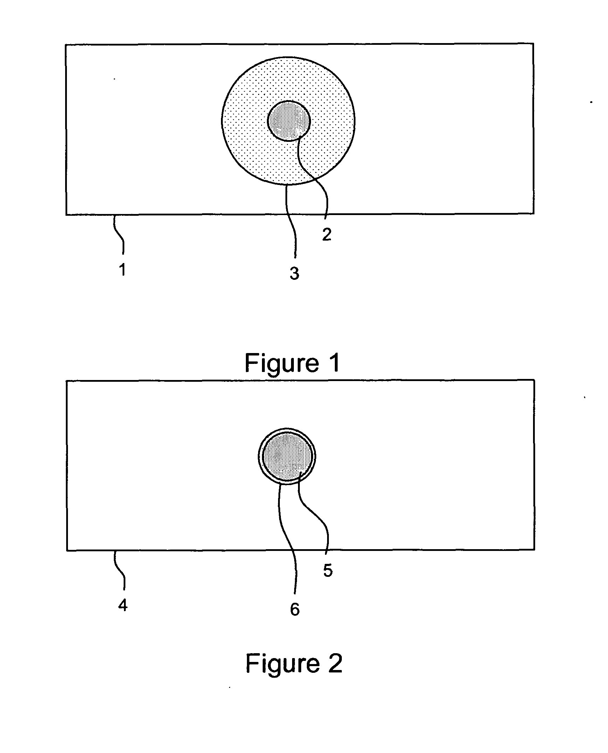

A problem with using adhesives is that they "bleed" over the surface once applied. This is illustrated in Figure 1. The ceramic surface 1 has a drop of adhesive 2 placed upon it. Where the adhesive drop 2 has a diameter of, for example, 1.5 mm, the adhesive on a typical untreated ceramic will bleed and spread to give a bleed region 3 a further 1.5 mm from the outside of the adhesive drop 2. The region of adhesive bleed is therefore far greater than the area of adhesive, and this is undesirable as it can have a detrimental effect on other nearby components.

It is known that the spreading of a liquid over a surface can be affected by modifying the surface energy of the surface and one way to do this is to treat the surface so that a layer or coating is placed upon the surface in order to alter its surface energy. However, this type of treatment is not used for components to which adhesives will be applied, as they also stop the adhesives adhering to the surface of the component. Materials that are commonly used in electronics and optoelectronics are ceramics such as alumina (Al₂O₃) and aluminium nitride (AIN), and metals such as copper and gold. The surfaces of such materials may differ from the bulk composition of the material. For example, copper and AIN my have oxide surface coatings through aerial oxidation. Any treatments used to modify the surface properties of the ceramics or metals therefore need to take account of the surface compositions of materials as used in industry.

The wetting properties of metallised ceramic substrates for use in optoelectronic assemblies are not specified or controlled by suppliers or optoelectronic module manufacturer customers, for the reasons mentioned above. The wetting properties of aluminium oxide and aluminium nitride substrate materials in the as received state are known to vary widely. Variation has also been shown to depend on storage and handling procedures implemented by the suppliers and customers of the substrates. Variation in the composition of the surfaces leads to poor process control of material interactions in assembly processes, such as the adhesion of metal tracks and the flow behaviour of adhesives for interconnections. Ceramics and metals have intrinsic high surface energies which favour low equilibrium contact angles for epoxy adhesives used for component mounting and interconnection. In extreme cases separation of epoxy components and bleed across the surface occurs, interfering with nearby components and contaminating sensitive areas such as wire bonding pads. Surface contamination of ceramic substrates tends to restrict spreading owing to wetting by reducing the effective surface energy. However, the variability of surface contamination levels of as received surfaces has so far made this an unreliable solution.

A self assembled monolayer (SAM) is a single molecule thick chemical layer which forms spontaneously on a given surface. The surface properties change from those of the bulk material to those of the SAM chemical following coating. Molecules of an amphiphilic substance (molecules having a hydrophilic head and a hydrophobic tail) are chemisorbed on a suitable solid surface, the hydrophilic end typically to the solid surface, leaving a hydrophobic tail exposed as a new surface. The exposure of the hydrophobic tail groups as a new surface and the uniform coverage of the solid surface reduces the apparent surface energy of a hydrophilic solid surface. The surface energy is an effect of the chemical and physical properties of the surface of the solid, the region where liquid/solid interactions take place. The reduction of this surface energy can increase the contact angle of liquids on the surface and thus reduce wetting. A well-known SAM is made from silane, for example treatment of a surface with trimethylchlorosilane. The treatment is sometimes known a silanisation.

An important practical point is that surfaces to be prepared for bonding are frequently composed of more than one material. For example, a surface may be made up of a ceramic with an embedded copper track and epoxy bonding may be required to both the ceramic and the metal surfaces. It is therefore important that a surface treatment can be effectively applied to both the ceramic and the metal components.

US2009/075087 describes a spin on protective coating for a wet-etch processing of microelectric substrates.

There is a need for means and methods of preparing the complex surfaces of materials to be bonded in the manufacture of optoelectronic devices so that adhesive bleed is reduced and minimised. It is also desirable for the whole complex surface composed of a variety of materials, such as ceramic and metal, to be homogenised in surface energy so that the whole surface gives minimal adhesive bleed.

### SUMMARY

The inventors have developed coatings and systems for coating substrates consisting of ceramics and/or metals to reduce the wetting of the surface of the substrate by an adhesive while still allowing the adhesive to bond sufficiently to the surface of the substrate.

According to a first aspect, there is provided a method of treating an electronic or optoelectronic component surface to be bonded with adhesive, the surface comprising at least a ceramic, the method comprising applying a coating that causes a reduction in the surface energy of the surface. The coating is applied by exposing the surface to a solution selected from any of an alkanoic acid, an alkyl phosphonic acid, an ester of an alkyl phosphonic acid, an aryl phosphonic acid, an ester of an aryl phosphonic acid, an alkenyl phosphonic acid and an ester of an alkenyl phosphonic acid.

Preferably, the coating comprises a self-assembled monolayer.

A solution may be used that comprises a molecule having a linear carbon chain. Alternatively, a solution may be used that comprises a molecule having a branched carbon chain.

As an option, an alkyl group of any of the alkanoic acid, the alkyl phosphonic acid or the ester of an alkyl phosphonic acid has the formula CₙH₍₂ₙ₊₁₎-.

In the event that an alkanoic acid is used, the alkanoic acid may comprise a fluoroalkanoic acid of the formula CₙF_{(2n+ 1)}COOH.

A chain length of an alkanoic acid may be between 8 and 21 carbon atoms.

It is preferred that the coating is applied so as to reduce the surface energy of the surface by at least 50 mN/m.

In one embodiment, the surface further comprises at least one region of metal. In this case, the method further comprises, prior to exposing the surface to a solution in order to apply a self-assembled monolayer, exposing the surface to a solution of comprising an alkanethiol.

As an option, the alkanethiol has a branched chain. The alkanethiol may have the formula CₙH_{(2n+1 )}SH, and furthermore may have a chain length of between 5 and 21 carbon atoms, or between 5 and 12 carbon atoms.

The coatings may be applied such that the surface of the metal and the surface of the ceramic have approximately equal surface energies.

According to a second aspect, there is provided an electronic or optoelectronic component having a substrate comprising a ceramic surface, the substrate comprising a surface coating that lowers the surface energy of the substrate. The coating is selected from any of an alkanoic acid, an alkyl phosphonic acid, an ester of an alkyl phosphonic acid, an aryl phosphonic acid, an ester of an aryl phosphonic acid, an alkenyl phosphonic acid and an ester of an alkenyl phosphonic acid.

The coating preferably comprises a self-assembled monolayer.

The coating may comprise a linear carbon chain or a branched carbon chain.

An alkyl group of any of the alkanoic acid, the alkyl phosphonic acid or the ester of an alkyl phosphonic acid preferably has the formula CₙH₍₂ₙ₊₁₎-.

In the event that an alkanoic acid is used, the alkanoic acid preferably comprises a fluoroalkanoic acid of the formula CₙF_{(2n+ 1)}COOH.

It is preferred that the coated substrate has a surface energy 50 mN/m lower than an equivalent substrate without the surface coating.

The substrate may further comprise at least one surface region of metal, the surface of the substrate further comprising a coating on the metal surface having been applied using an alkanethiol.

The alkanethiol preferably has a branched chain.

As an option, the alkanethiol has the formula CₙH₍₂ₙ₊₁₎SH.

The alkanethiol optionally has a chain length of between 5 and 21 carbon atoms, and preferably a chain length of between 5 and 12 carbon atoms.

As an option, the coatings are applied to the substrate such that the surface region of metal and the ceramic surface have approximately equal surface energies.

In an optional embodiment, the coating comprises a monolayer of carboxylic acid that does not reduce adhesion between an adhesive and the surface.

### BRIEF DESCRIPTION OF THE DRAWINGS

Figure 1 illustrates schematically a plan view of adhesive bleed on a ceramic material;
Figure 2 illustrates a plan view of adhesive bleed on the same ceramic as shown in Figure 1 and after treatment according to an embodiment of the invention;
Figure 3 shows a relationship between the bleed distance and carbon chain length for a ceramic treated with linear fluoroalkanoic acids; and
Figure 4 shows a relationship between surface energy of a ceramic surface treated with fluoroalkanoic acid and the carbon chain length for linear fluoroalkanoic acids.

### DETAILED DESCRIPTION

Referring to Figure 2 herein, a material made up of at least one ceramic material 4 has its surface treated with a solution of an alkanoic acid, a phosphonic acid or a silane. After washing and drying of the surface, a component or device is bonded to the surface using an adhesive, such as an epoxy adhesive 5. The bleed region 6 of the adhesive is greatly reduced with no significant effect of the bond strength achieved between the component or device and the ceramic substrate, in the case of the alkanoic acid. For example, it has been found that where a fluorinated carboxylic acid such as perflourooctanoic acid is used as the surface treatment, a drop of adhesive having a diameter of 1.5 mm will have a bleed region that only extends a further 0.1 mm from the outside of the adhesive drop. Note that silane and phosphonic acid monolayers can be used where bond strength is not imperative.

In the case where a surface is made up of at least one ceramic and at least one metal, having a surface with exposed ceramic and exposed metal, the surface is treated with an alkanethiol to modify the surface properties of the metal, followed by one of the ceramic treatments mentioned above to reduce the surface energy across the surface so that the spread of uncured and curing adhesive is reduced.

The reason that the alkanethiol is applied first is that it will form a coating on the metal but will not form a coating on the ceramic. This effectively 'masks' the metal when a ceramic coating is subsequently applied. When the coating for the ceramic is applied, it coats the ceramic but will not coat the metal coating with the alkanethiol. In this way, the substrate is coated such that different coatings are applied to the ceramic and metal surfaces of the substrate.

Furthermore, the alkanethiol is applied first to ensure that any oxidized metal is not adhered to by the coating meant to be applied to the ceramic portion of the substrate.

It has been found that a longer chain length SAM chemical will reduce bleed more effectively than a shorter one. Any chain length can be used providing it can be dissolved in a solvent which does not interfere with the chemisorption process.

### Example 1

A technique for coating ceramic with alkanoic acid is described below:
Step 1. CA₃(CB₂)*ₙ*COOH is dissolved in deionised water or another suitable solvent, typically at 60°C to make an approximately 0.01 M solution. In this example. A and B are any of hydrogen, chlorine and fluorine, n is an integer from 1 to 21. An aqueous solution may not be suitable for all compositions, although other types of solvent can be used. In this example, A = flourine, B = flourine and n = 1 to 16.
Step 2. Expose the ceramic (typically Al₂O₃ or AIN) to the solution. The exposure in this example is at approximately 60°C for up to approximately one hour but other conditions may be suitable depending upon the solid substrate and the alkanoic acid used.
Step 3. Remove the ceramic from the treatment solution and wash with thoroughly with deionised water.
Step 4. Dry the ceramic.

This type of coating gives the results shown in Figure 2.

### Example 2

A further technique has been developed for coating a metal surface. It can also be used for coating a surface that includes metal and ceramic components
Step 1. Dissolve organosulphide into isopropylalcohol (propan-2-ol, or another suitable solvent, typically a hydroxylic solvent) to obtain a concentration of 10mM.
Step 2. The surface may require preparation of surfaces before SAM treatment. Where the metal is copper or another metal that forms an oxide layer, it is etched with dilute (∼5%) HCl for 10 minutes to remove the oxide layer. The SAM solution is preferably acidified with 40ml/l of acetic acid. Gold needs no preparative treatment.
Step 3. The metal surface is exposed to the coating solution (from step 1 or as modified for copper in step 2). The surface exposed to the solution for a period of up to approximately one hour. This operation is typically effected at room temperature.
Step 4. The metal is removed from the treatment solution and washed thoroughly with solvent such as isopropylalcohol.
Step 5. The surface is dried.
Step 6. Where the surface also contains a ceramic requiring reduced bleed characteristics, the alkanoic acid treatment is then applied as above, or the silane and phosphonic acid treatment as below.

SAM substances suited to this type of treatment are those with the chemical formula HS-R or R-S-S-A where R and A are alkyl or aryl chains which could be partially or totally fluorinated or chlorinated. The hydrocarbon chains will terminate in a methyl, ethyl, fluorinated methyl or chlorinated methyl tail group.

### Example 3

The technique described in example 3 is for coating ceramic with silane or phosphonic acid SAMs

Step 1. Prepare a solution of phosphonic acid or silane to a concentration of 0.01 M. Examples of suitable solvents include ethanol for phosphonic acid and cyclohexane for silanes.

Step 2. The ceramic (typically Al₂O₃ AIN) is exposed to the solution. The exposure is at approximately 20°C for up to approximately one hour but other conditions may be suitable depending upon the solid substrate and the SAM substance used.

Step 3. Remove the ceramic from the treatment solution and wash with thoroughly with the respective solvent.

### Step 5. Dry.

SAM substances suited to this technique when silanes are used are those with a silane group and general formula R-SiA₃ where A can be hydrogen, chlorine or fluorine and R is a linear or branched alkyl or aryl chain of length 1-21 carbon atoms which could be partially or totally chlorinated of fluorinated.

SAM substances suited to this technique when phosphonic acid SAMs are used are those with a phosphonic acid group of the form R-PO(OH)₂ where R is an alkyl or aryl chain which could be partially or totally chlorinated of fluorinated or alternatively an ester thereof such as R-PO(OR')(OR") where R' and R" are the same or different and are typically short chain alkyl groups such as methyl or ethyl. The most effective phosphonic acids (halogenated or not) SAMs in this application have from 5 to 12 carbon atoms but from 1 to 21 will have some effect.

The performance of the treatments is assessed by measuring the distance the adhesive spreads away from the base of the item to be adhered to the test surface. For an untreated surface in ceramic the spread is typically 2mm. For an untreated metal it is typically 1 mm. After treatments described above the bleed is reduced to approximately 30µm for ceramic or metal using the thiol and alkanoic acid treatments.

The SAM treatments produce mono layers, and such monolayers are resistant to removal by solvent cleaning processes. The presence of SAM monolayers on ceramics and metals treated as above has been confirmed with XPS both before and after solvent cleaning. The protection of the metal from alkanoic acid by the alkanethiol mono layer has also been shown with XPS.

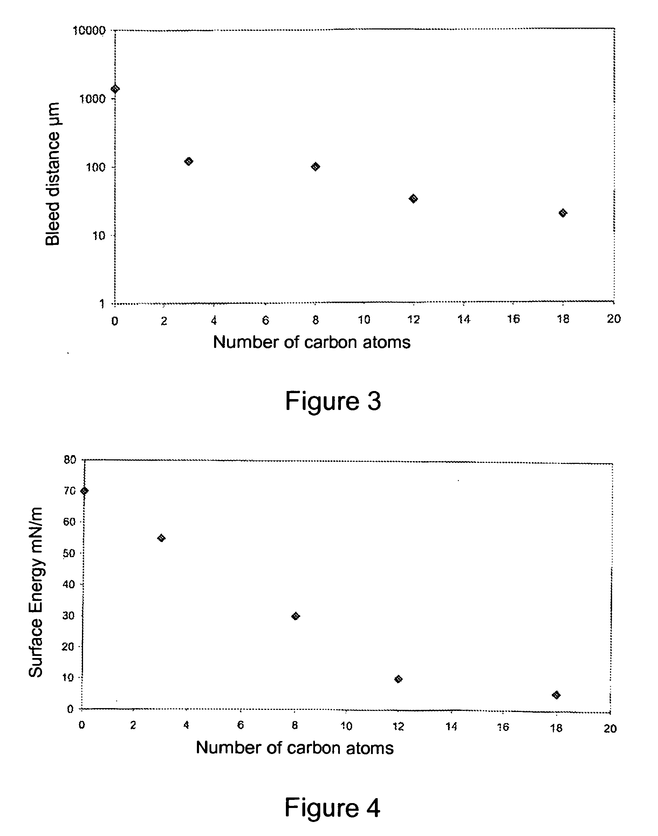

Referring to Figure 3 herein, there is shown the bleed distance as a function of a fluorinated carboxylic acid SAM chain length. Note that the bleed distance is shown on a logarithmic scale. It can be seen that the bleed distance reduces dramatically as the number of carbon atoms in the SAM increases.

Referring to Figure 4 herein, there is shown the surface energy of the ceramic surface as a function of the number of carbon atoms in a flouralkanoic acid SAM chain. Again, it can be seen that the surface energy decreases greatly with the number of carbon atoms.

The adhesives used in the tests were
1) Epo-Tek 930-4 (boron nitride loaded thermally conductive/electrically insulative);
2) H20E (silver loaded electrically conductive); and
3) an adhesive prepared from 2-ethyl-4-methylimidazole (curing agent dissolved in 1,2-propanediol) and poly((phenyl glycidyl ether)-coformaldehyde).

Surprisingly, the shear strength of epoxy bonds to the ceramics was not affected by the coatings, with joints failing cohesively for both coated and uncoated samples. The SAMs were shown to be thermally stable, being unaffected by heat soaking at 150°C for 12 hours, augmenting their suitability as a solution to the problem of bleed.

The measured shear strengths of the commercial adhesives (on the ceramics) were 34.6N/mm² and 23.9N/mm² respectively, both before and after the ceramics were treated. The adhesives always underwent cohesive failure, showing that there was no strength reduction at the interface. This has been done repeatedly with 4 lengths of fluorinated carboxylic acid, with all 3 epoxy adhesives described above. Using a silane SAM (which has a stronger bond), the shear strength is reduced to almost zero and the failure mode changes to adhesive failure. The surface energy is, however, higher than the fluorinated carboxylic acid SAM coated surfaces.

Using well-known SAMs such as silanes, a large drop in the strength of the bond between the adhesive and the surface is observed owing to the reduction in surface energy. This is because reduced surface area reduces the Van Der Waals forces, which gives less wetting and hence less contact between the surface and the adhesive. However, the reduction in strength between the adhesive and the surface when using the coatings described above either does not occur or occurs to acceptable levels. While the exact mechanism for this is not fully understood, it is tentatively suggested that this may be because carboxylic acid SAM molecules are displaced by the reactive curing agent in the adhesive. This has been shown to occur by XPS data. This displacement happens sufficiently slowly that bleed does not occur significantly at the three phase line (the line between the adhesive, the SAM and the solid surface) but bond strength is regained at the interface under the adhesive bulk. This is the reason the bleed distance is not zero. In other words, the adhesive attacks the coating slowly to allow it to form a good bond with the surface, but not sufficiently quickly to allow significant levels of bleed to occur.

## Claims

1. A method of treating an electronic or optoelectronic component surface to be bonded with adhesive, the surface comprising at least a ceramic, the method **characterised by** applying a coating that causes a reduction in the surface energy of the surface, and further comprising;
applying the coating by exposing the surface to a solution selected from any of an alkanoic acid, an alkyl phosphonic acid, an ester of an alkyl phosphonic acid, an aryl phosphonic acid, an ester of an aryl phosphonic acid, an alkenyl phosphonic acid and an ester of an alkenyl phosphonic acid.

2. The method according to claim 1 wherein the coating comprises a self-assembled monolayer.

3. The method according to claims 1 or 2, comprising using any of a solution comprising a molecule having a linear carbon chain, and a solution comprising a molecule having a branched carbon chain, and preferably wherein an alkyl group of any of the alkanoic acid, the alkyl phosphonic acid or the ester of an alkyl phosphonic acid has the formula CₙH₍₂ₙ₊₁₎-, and preferably wherein in the event that an alkanoic acid is used, the alkanoic acid comprises a fluoroalkanoic acid of the formula CₙF_{(2n+ 1)}COOH, and preferably wherein a chain length of the alkanoic acid is between 8 and 21 carbon atoms.

4. The method according to any of claims 1 to 3, wherein the coating is applied so as to reduce the surface energy of the surface by at least 50 mN/m.

5. The method according to any of claims 1 to 4, wherein the surface further comprises at least one region of metal, the method comprising, prior to exposing the surface to a solution in order to apply a self-assembled monolayer, exposing the surface to a solution of comprising an alkanethiol.

6. The method according to claim 5 where the alkanethiol has any of a branched chain, the formula CₙH_{(2n+1 )}SH, a chain length of between 5 and 21 carbon atoms, and a chain length of between 5 and 12 carbon atoms.

7. The method according to claim 5 or 6, wherein the surface of the metal and the surface of the ceramic have approximately equal surface energies.

8. An electronic or optoelectronic component having a substrate comprising a ceramic surface, the substrate **characterised by** a surface coating that lowers the surface energy of the substrate, and wherein the coating is selected from any of an alkanoic acid, an alkyl phosphonic acid, an ester of an alkyl phosphonic acid, an aryl phosphonic acid, an ester of an aryl phosphonic acid, an alkenyl phosphonic acid and an ester of an alkenyl phosphonic acid.

9. The electronic or optoelectronic component according to claim 8 wherein the coating comprises a self-assembled monolayer.

10. The electronic or optoelectronic component according to claim 8 wherein the coating comprises one of a linear carbon chain and a branched carbon chain.

11. The electronic or optoelectronic component according to claim 8, wherein an alkyl group of any of the alkanoic acid, the alkyl phosphonic acid or the ester of an alkyl phosphonic acid has the formula CₙH₍₂ₙ₊₁₎- and, in the event that an alkanoic acid is used, the alkanoic acid preferably comprises a fluoroalkanoic acid of the formula CₙF_{(2n+ 1)}COOH.

12. The electronic or optoelectronic component according to any of claims 8 to 11, having a surface energy of 50 mN/m lower than an equivalent substrate without the surface coating.

13. The electronic or optoelectronic component according to any of claims 8 to11, wherein the substrate further comprises at least one surface region of metal, the surface of the substrate further comprising a coating on the metal surface having been applied using an alkanethiol, wherein the alkanethiol has one of a branched chain, the formula CₙH_{(2n+1 )}SH, a chain length of between 5 and 21 carbon atoms, and a chain length of between 5 and 12 carbon atoms.

14. The electronic or optoelectronic component according to claim 8, wherein the coating comprises a monolayer of carboxylic acid that does not reduce adhesion between an adhesive and the surface.

## Patentansprüche

1. Verfahren zum Behandeln einer elektronischen oder optoelektronischen Komponentenoberfläche, die mit Klebstoff bondiert werden soll, wobei die Oberfläche mindestens ein Keramikmaterial umfasst, wobei das Verfahren durch Aufbringen einer Beschichtung gekennzeichnet ist, die eine Reduktion der Oberflächenenergie der Oberfläche verursacht, und des Weiteren Folgendes umfassend:
das Aufbringen der Beschichtung durch Aussetzen der Oberfläche einer Lösung gegenüber, die unter irgendeinem von einer Alkansäure, einer Alkylphosphonsäure, einem Ester einer Alkylphosphonsäure, einer Arylphosphonsäure, einem Ester einer Arylphosphonsäure, einer Alkenylphosphonsäure und einem Ester einer Alkenylphosphonsäure ausgewählt wird.

2. Verfahren nach Anspruch 1, wobei die Beschichtung eine selbstorganisierende Monoschicht umfasst.

3. Verfahren nach Anspruch 1 oder 2, umfassend das Verwenden irgendeiner Lösung umfassend ein Molekül, das eine lineare Kohlenstoffkette aufweist, und einer Lösung umfassend ein Molekül umfasst, das eine verzweigte Kohlenstoffkette aufweist, und wobei bevorzugt eine Alkylgruppe irgendeiner von der Alkansäure, der Alkylphosphonsäure oder dem Ester einer Alkylphosphonsäure die Formel CₙH₍₂ₙ₊₁₎ aufweist und wobei bevorzugt in dem Fall, in dem eine Alkansäure verwendet wird, die Alkansäure eine Fluoralkansäure der Formel CₙF₍₂ₙ₊₁₎COOH umfasst und wobei bevorzugt eine Kettenlänge der Alkansäure zwischen 8 und 21 Kohlenstoffatomen liegt.

4. Verfahren nach einem der Ansprüche 1 bis 3, wobei die Beschichtung aufgebracht wird, um die Oberflächenenergie der Oberfläche um mindestens 50 mN/m zu reduzieren.

5. Verfahren nach einem der Ansprüche 1 bis 4, wobei die Oberfläche des Weiteren mindestens eine Region aus Metall umfasst, wobei das Verfahren vor Aussetzen der Oberfläche einer Lösung gegenüber, um eine selbstorganisierende Monoschicht aufzubringen, das Aussetzen der Oberfläche einer Lösung, die Alkanthiol umfasst, gegenüber umfasst.

6. Verfahren nach Anspruch 5, wobei das Alkanthiol irgendeines von einer verzweigten Kette, der Formel CₙF₍₂ₙ₊₁₎SH, einer Kettenlänge zwischen 5 und 21 Kohlenstoffatomen und einer Kettenlänge zwischen 5 und 12 Kohlenstoffatomen aufweist.

7. Verfahren nach Anspruch 5 oder 6, wobei die Oberfläche des Metalls und die Oberfläche des Keramikmaterials etwa gleiche Oberflächenenergien aufweisen.

8. Elektronische oder optoelektronische Komponente, die ein Substrat aufweist, das eine Keramikoberfläche umfasst, wobei das Substrat durch eine Oberflächenbeschichtung gekennzeichnet ist, die die Oberflächenenergie des Substrats reduziert und wobei die Beschichtung unter irgendeinem ausgewählt ist von einer Alkansäure, einer Alkylphosphonsäure, einem Ester einer Alkylphosphonsäure, einer Arylphosphonsäure, einem Ester einer Arylphosphonsäure, einer Alkenylphosphonsäure und einem Ester einer Alkenylphosphonsäure.

9. Elektronische oder optoelektronische Komponente nach Anspruch 8, wobei die Beschichtung eine selbstorganisierende Monoschicht umfasst.

10. Elektronische oder optoelektronische Komponente nach Anspruch 8, wobei die Beschichtung eine von einer linearen Kohlenstoffkette und einer verzweigten Kohlenstoffkette umfasst.

11. Elektronische oder optoelektronische Komponente nach Anspruch 8, wobei eine Alkylgruppe von irgendeinem von der Alkansäure, der Alkylphosphonsäure oder dem Ester einer Alkylphosphonsäure die Formel CₙH₍₂ₙ₊₁₎ aufweist und wobei in dem Fall, in dem eine Alkansäure verwendet wird, die Alkansäure bevorzugt eine Fluoralkansäure der Formel CₙF₍₂ₙ₊₁₎COOH umfasst.

12. Elektronische oder optoelektronische Komponente nach einem der Ansprüche 8 bis 11, die eine Oberflächenenergie aufweist, die 50 mN/m geringer ist als diejenige eines äquivalenten Substrats ohne die Oberflächenbeschichtung.

13. Elektronische oder optoelektronische Komponente nach einem der Ansprüche 8 bis 11, wobei das Substrat des Weiteren mindestens eine Oberflächenregion aus Metall umfasst, wobei die Oberfläche des Substrats des Weiteren eine Beschichtung auf der Metalloberfläche aufweist, die unter Anwendung eine Alkanthiols aufgebracht worden ist, wobei das Alkanthiol eines von einer verzweigten Kette, der Formel CₙF₍₂ₙ₊₁₎SH, einer Kettenlänge zwischen 5 und 21 Kohlenstoffatomen und einer Kettenlänge zwischen 5 und 12 Kohlenstoffatomen aufweist.

14. Elektronische oder optoelektronische Komponente nach Anspruch 8, worin die Beschichtung eine Monoschicht aus Carbonsäure aufweist, die die Haftung zwischen einem Kleber und der Oberfläche nicht reduziert.

## Revendications

1. Procédé de traitement d'une surface de composant électronique ou optoélectronique à lier avec un adhésif, la surface comprenant au moins une céramique, le procédé étant **caractérisé par** l'application d'un revêtement qui provoque une réduction de la tension superficielle de la surface, et comprenant en outre;
l'application du revêtement par exposition de la surface à une solution sélectionnée parmi un acide alcanoïque, un acide alkyl phosphonique, un ester d'un acide alkyl phosphonique, un acide aryl phosphonique, un ester d'un acide aryl phosphonique, un acide alcényl phosphonique et un ester d'un acide alcényl phosphonique.

2. Procédé selon la revendication 1 dans lequel le revêtement comprend une monocouche auto-assemblée.

3. Procédé selon les revendications 1 ou 2, comprenant l'utilisation de n'importe laquelle d'une solution comprenant une molécule ayant une chaîne carbonée linéaire, et une solution comprenant une molécule ayant une chaîne carbonée ramifiée, et de préférence dans laquelle un groupe alkyle de n'importe lequel parmi l'acide alcanoïque, l'acide alkyl phosphonique ou l'ester d'un acide alkyl phosphonique a la formule CₙH₍₂ₙ₊₁₎₋, et par ailleurs de préférence dans le cas d'utilisation d'un acide alcanoïque, l'acide alcanoïque comprend un acide fluoroalcanoïque de la formule CₙF₍₂ₙ₊₁₎COOH, et où de préférence une longueur de chaîne de l'acide alcanoïque est comprise entre 8 et 21 atomes de carbone.

4. Procédé selon l'une quelconque des revendications 1 à 3, dans lequel le revêtement est appliqué afin de réduire la tension superficielle de la surface d'au moins 50 mN/m.

5. Procédé selon l'une quelconque des revendications 1 à 4, dans lequel la surface comprend en outre au moins une région métallique, le procédé comprenant, avant l'exposition de la surface à une solution permettant d'appliquer une monocouche auto-assemblée, l'exposition de la surface à une solution comprenant un alcanethiol.

6. Procédé selon la revendication 5 où l'alcanethiol possède n'importe laquelle parmi une chaîne ramifiée, la formule CₙH₍₂ₙ₊₁₎SH, une longueur de chaîne comprise entre 5 et 21 atomes de carbone, et une longueur de chaîne comprise entre 5 et 12 atomes de carbone.

7. Procédé selon la revendication 5 ou 6, dans lequel la surface métallique et la surface de la céramique ont des énergies de surface approximativement égales.

8. Composant électronique ou optoélectronique ayant un substrat comprenant une surface en céramique, le substrat étant **caractérisé par** un revêtement de surface qui réduit la tension superficielle du substrat, et où le revêtement est sélectionné parmi n'importe lequel parmi un acide alcanoïque, un acide alkyl phosphonique, un ester d'un acide alkyl phosphonique, un acide aryl phosphonique, un ester d'un acide aryl phosphonique, un acide alcényl phosphonique et un ester d'un acide alcényl phosphonique.

9. Composant électronique ou optoélectronique selon la revendication 8 dans lequel le revêtement comprend une monocouche auto-assemblée.

10. Composant électronique ou optoélectronique selon la revendication 8 dans lequel le revêtement comprend l'une parmi une chaîne carbonée linéaire et une chaîne carbonée ramifiée.

11. Composant électronique ou optoélectronique selon la revendication 8, dans lequel un groupe alkyle de n'importe lequel parmi l'acide alcanoïque, l'acide alkyl phosphonique ou l'ester d'un acide alkyl phosphonique a la formule CₙH₍₂ₙ₊₁₎₋ et, dans l'éventualité où un acide alcanoïque est utilisé, l'acide alcanoïque comprend de préférence un acide fluoroalcanoïque de la formule CₙF₍₂ₙ₊₁₎COOH.

12. Composant électronique ou optoélectronique selon l'une quelconque des revendications 8 à 11, ayant une tension superficielle de 50 mN/m inférieure à celle d'un substrat équivalent sans le revêtement de surface.

13. Composant électronique ou optoélectronique selon l'une quelconque des revendications 8 to 11, dans lequel le substrat comprend en outre au moins une région superficielle métallique, la surface du substrat comprenant en outre un revêtement sur la surface métallique ayant été appliqué en utilisant un alcanethiol, où l'alcanethiol a l'une parmi une chaîne ramifiée, la formule CₙH₍₂ₙ₊₁₎SH, une longueur de chaîne comprise entre 5 et 21 atomes de carbone, et une longueur de chaîne comprise entre 5 et 12 atomes de carbone.

14. Composant électronique ou optoélectronique selon la revendication 8, dans lequel le revêtement comprend une monocouche d'acide carboxylique qui ne réduit pas l'adhésion entre un adhésif et la surface.
